(19) Europäisches Patentamt
European Patent Office
Office européen des brevets

(11) EP 1 696 521 A2

(12) EUROPEAN PATENT APPLICATION

(43) Date of publication:
30.08.2006 Bulletin 2006/35

(51) Int Cl.:
H01S 3/106 (2006.01)    H01S 3/137 (2006.01)
H01S 5/14 (2006.01)

(21) Application number: 05009727.8

(22) Date of filing: 03.05.2005

(84) Designated Contracting States:
AT BE BG CH CY CZ DE DK EE ES FI FR GB GR
HU IE IS IT LI LT LU MC NL PL PT RO SE SI SK TR
Designated Extension States:
AL BA HR LV MK YU

(30) Priority: 15.02.2005 US 58152

(71) Applicant: Agilent Technologies Inc. (a Delaware
Corporation)
Palo Alto, CA 94306-2024 (US)

(72) Inventors:
• Owen, Geranit
Loveland, CO 80537-0599 (US)
• Trutna Jr., William R.
Loveland, CO 80537-0599 (US)

(74) Representative: Schoppe, Fritz et al
Schoppe, Zimmermann, Stöckeler & Zinkler
Patentanwälte
Postfach 246
82043 Pullach bei München (DE)

(54) Tuning a laser

(57) A method for synchronously tuning a laser in a laser system (150) having a set of possible resonant frequencies including a resonating mode resonant frequency, an optical amplifier (14) with an optical gain and a mode filter having a pass band (36, 50) with a center frequency, includes the steps of determining the optical gain of the optical amplifier (14) and providing an optical gain signal representative of the optical gain. The center frequency of the pass band (36, 50) is adjusted in accordance with the optical gain signal to move the center frequency of the pass band (36, 50) toward the resonating mode resonant frequency (38, 52). An error signal is determined in accordance with the optical gain signal and the center frequency of the pass band (36, 50) is adjusted by a servo system in accordance with the error signal. The center frequency of the pass band (36, 50) is also adjusted in accordance with a signal representative of an acoustic frequency.

FIG.2

EP 1 696 521 A2

**Description**

**BACKGROUND OF THE INVENTION**

In order to tune a laser in a single mode without mode hops, the cavity and the mode selecting filter of the laser must be tuned synchronously. In the known art of mechanical tuning of lasers, synchronous tuning ranges of many tens of nanometers of wavelength could be achieved by rotating a cavity mirror or diffraction grating about a specific pivot point. Only one location of the pivot point provided synchronous tuning of the lasers. The Littman and Littrow configurations are well known examples of this type of mechanically tuned lasers.

The mechanical tolerance of the pivot position in the mechanically tuned lasers could be on the order of 1 $\mu m$ or less and achieving this tolerance is expensive. Furthermore, the location of the pivot point may vary with temperature and air pressure. It may also vary slightly with oscillation wavelength. For these reasons, it would be attractive to be able to adjust lasers for synchronicity without physically moving the pivot point. A static method for doing this is described in U.S. Patent Application No. 2004/0075919 A1. A dynamic method is described in U.S. Patent No. 6,763,044.

However, being able to compensate for errors in the pivot location is only part of the problem. It is also necessary to know how much compensation must be applied when parameters such as temperature or air pressure change. One method for doing this is described in U.S. Patent Application No. 2004/0109479 A1. The method taught therein is a feed forward technique. It relies on characterizing the laser by a mathematical model in terms of parameters such as ambient temperature. When the temperature changes, the resulting pivot point error is estimated from the model and a correction is applied on this basis. A disadvantage of this technique is that it requires a complete and accurate model of the laser. This is difficult to achieve in practice, especially as the laser's behavior may not be time invariant. A true negative feedback method would be a significant improvement, and is described here

**BRIEF SUMMARY OF THE INVENTION**

In one aspect, a method of synchronously tuning a laser according to the principles of the invention may be practiced in a laser system of the kind having an optical amplifier and a mode filter. The optical amplifier has an optical gain. The mode filter has a pass band with a center frequency. The laser system has a set of possible resonant frequencies including a resonating mode resonant frequency. The method includes the steps of determining the optical gain of the optical amplifier, providing an optical gain signal representative of the optical gain, and adjusting the center frequency of the pass band in accordance with the optical gain signal to move the center frequency of the pass band toward the resonating mode resonant frequency.

In another aspect, an apparatus for synchronously tuning a laser in a laser system has a set of possible resonant frequencies including a resonating mode resonant frequency and a mode filter having a pass band with a center frequency. The apparatus has an optical amplifier having an optical gain and a frequency shifter. The frequency shifter shifts the center frequency of the pass band in accordance with the optical gain to move the center frequency of the pass band toward the resonating mode resonant frequency.

**BRIEF DESCRIPTION OF SEVERAL VIEWS OF THE DRAWINGS**

The invention will be described in conjunction with the following drawings in which like reference numerals designate like elements and wherein:

Fig. 1 shows a schematic representation of an acousto-optically tuned external cavity laser system.

Fig. 2 shows a graphical representation of a synchronous tuning process that can be performed upon the acousto-optically tuned external cavity laser system of Fig. 1.

Figs. 3A, 3B show graphical representations illustrating the peak response of the mode filter of the acousto-optically tuned external cavity laser of Fig. 1 relative to the resonance frequency thereof.

Fig. 4 shows a schematic representation of an alternate embodiment of the acousto-optically tuned external cavity laser system of Fig. 1 for measuring the optical gain therein.

Fig. 5 shows a schematic representation of an alternate embodiment of the acousto-optically tuned external cavity laser system of Fig. 4 wherein a negative feedback servo has been provided for permitting synchronous tuning of the laser system.

Fig. 6 shows a graphical representation illustrating the relationship between the total cavity transmission and the optical gain of an the optical amplifier within the acousto-optically tuned external cavity laser system of Fig. 5.

Fig 7 shows a linear laser cavity suitable for use in the laser system of the present invention.

## DETAILED DESCRIPTION OF THE INVENTION

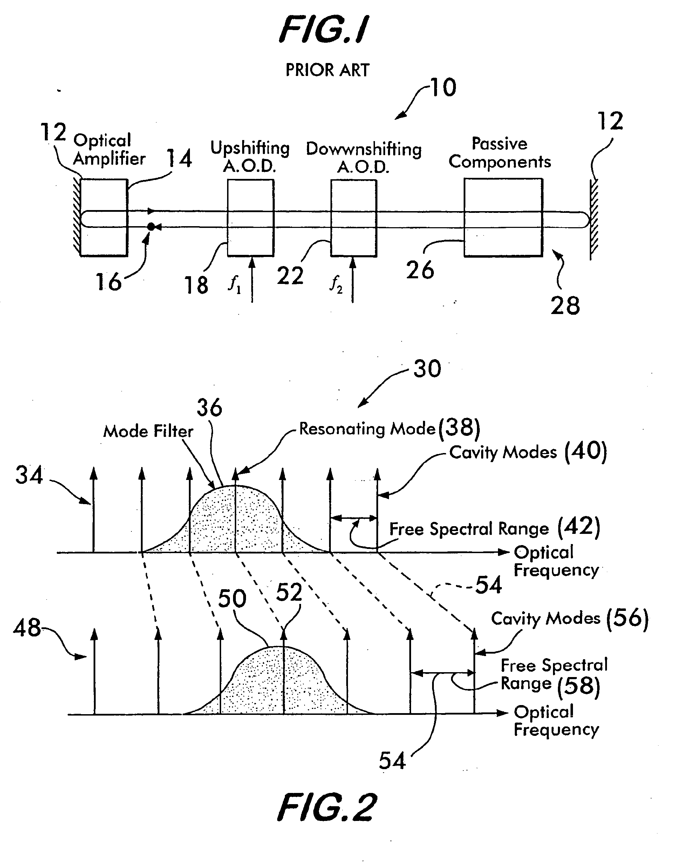

Referring now to Fig. 1, there is shown a schematic representation of a prior art acousto-optically tuned external cavity laser system 10, wherein the mirrors 12 define the cavity 28 of the laser system 10. The cavity 28 of the acousto-optically tuned external cavity laser system 10 is adapted to permit the light beams 16 to bounce back and forth between the mirrors 12 when the external cavity laser system 10 is operating in its resonant mode. The cavity 28 of the external cavity laser system 10 also includes an upshifting acousto-optic device (A.O.D.) 18 and a downshifting A.O.D. 22 for frequency shifting the light beams 16. The types of acousto-optical devices used in a particular laser design could include, but not be limited to deflectors, filters, modulators, or combinations of these types.

When the upshifting A.O.D. 18 and the downshifting A.O.D. 22 frequency shift the light beams 16 they change the resonant modes within the external cavity laser system 10 by allowing the light beams 16 to interact with acoustic waves without the need for any mechanical movement of any elements within the laser system 10. For example, if an optical frequency $v$ and an acoustic frequency $f_1$ are applied to the upshifting A.O.D. 18 an optical frequency $v + f_1$ can be produced at the output of the upshifting A.O.D.18. Additionally, if an optical frequency $v$ and an acoustic frequency $f_2$ are applied to the downshifting A.O.D. 22 an optical frequency $v - f_2$ can be produced at the output of the downshifting A.O.D. 22. In this manner it is possible to introduce small changes in the optical frequency of the light beams 16 as they travel within the cavity 28 of the laser system 10.

It will be understood by those skilled in the art that there are many possible resonant modes within the acousto-optically tuned external cavity laser system 10 since the wavelength of the light beams 16 is substantially small compared with the length of the cavity 28 defined by the mirrors 12. Therefore, other components such as filters within the passive components block 26 are provided to attenuate all resonant modes except the desired one in a manner well known to those skilled in the art. The passive components block 26 of the external cavity laser system 10 can also include other known devices that would be necessary in a practical design such as diffraction gratings and additional mirrors.

Referring now to Fig. 2, there is shown a graphical representation 30 of a synchronous tuning process that can be performed upon a laser system such as the acousto-optically tuned external cavity laser system 10. The graphical representation 30 includes a graphical representation 34 which represents the state of the external cavity laser system 10 prior to the synchronous tuning process. The graphical representation 30 also includes a graphical representation 48 which represents the state of the external cavity laser system 10 after the synchronous tuning process.

The graphical representation 34 shows some of the possible cavity modes 40 of the mode filter of the external cavity laser system 10 as vertical arrows. The separation between the cavity modes 40 is known as the free spectral range (F.S.R.) 42. The F.S.R. 42 can typically be in the GHz region. The pass band of the mode filter of the external cavity laser system 10 is represented as the bell shaped filter curve 36 within the graphical representation 34. The center frequency of the pass band of the filter curve 36 is selected to be approximately equal to the desired resonant frequency of the external cavity laser system 10 Thus only one of the many possible cavity modes 40 of the graphical representation 34 is oscillating, the resonating cavity mode 38.

The graphical representation 48 shows the state of the external cavity laser system 10 after it has been tuned. When the cavity 28 is tuned each cavity mode 56 of the graphical representation 48 is shifted compared to the cavity modes 40. The shifting of the cavity modes 56 relative to the cavity modes 40 is indicated by the dashed lines 54. If the external cavity laser system 10 is to oscillate continuously without mode hops as it is tuned in this manner, the filter curve 50 must shift in synchronism with the resonating mode of the laser system 10 as it moves from the resonating cavity mode 38 to the resonating cavity mode 52. This process is known as synchronous tuning.

In the system and method of the present invention the synchronous movement of the filter curve 50 and the resonating mode 52 can be accomplished as follows. The acoustic frequency $f_1$ is applied to the upshifting A.O.D. 18 and the acoustic frequency $f_2$ is applied to the downshifting A.O.D. 22 as previously described. In practical tuned external cavity lasers such as the external cavity laser system 10, $f_1$, and $f_2$ are selected such that $f_1 \approx f_2 = f$ and $f_1 - f_2 = \Delta f$ where $\Delta f << f$. Under these conditions, let the optical frequency at which the external cavity laser system 10 is oscillating be $v$ , and let the round-trip transit time of the cavity 28 be T. Then the equation governing the rate of change of optical frequency $v$ during tuning of the cavity 28 is

$$\frac{dv}{dt} = \frac{2\Delta f}{T} .$$   Equation (1)

In one preferred embodiment of the invention the acoustic frequency $f$ can be in the range of approximately 50 to 1000 *MHz* and the optical frequency can be in the range of approximately 100 to 500 THz. The transit time T for the cavity 28 within the laser system 10 with an F.S.R. 42 of 2 GHz is 500 ps. The rate of change of the optical frequency v, can be in the range 10 to 1000 *THz/s.*

To those skilled in the art it is well known that the pass frequency of the mode selecting filter can be controlled by varying the acoustic frequency f. The corresponding variation in pass frequency depends on the type and design of the A.O. D.18, 22, the type and design of the passive components 26 and the way the AOD 18, 22 and the passive components 26 interact. Notwithstanding the foregoing components, the mode filter of the external cavity laser system 10 is characterized by the quantity $\left(\dfrac{dv}{df}\right)$, i.e. the rate of change of the pass frequency of the filter with respect to acoustic frequency. Typically this rate of change can have a value of $10^6$. The equation governing the tuning of the mode filter is

$$\frac{dv}{dt} = \left(\frac{dv}{df}\right) \times \frac{df}{dt} = \frac{df}{dt}\left(\frac{dv}{df}\right). \qquad \text{Equation (2)}$$

Thus, for synchronous tuning

$$\frac{\Delta f}{T} = \frac{1}{2}\frac{df}{dt}\left(\frac{dv}{df}\right). \qquad \text{Equation (3)}$$

It is understood by those skilled in the art that both T and $\left(\dfrac{dv}{df}\right)$ are functions of v. Furthermore, it is known that they are also dependent on environmental factors such as ambient temperature and pressure. The foregoing dependencies are weak, but nevertheless important. As a result, it may be necessary to continuously adjust the acoustic frequency f if the external cavity laser system 10 is to tune continuously over a wide range of wavelengths. This is particularly true when ambient conditions around the external cavity laser system 10 are changing. This problem is addressed in accordance with the present invention by providing an optical gain within the external cavity laser system 10 that is at or substantially near a minimum when the cavity oscillation frequency of the resonating cavity mode 38 is centered within the pass band of the mode filter. As previously described, this is shown as the bell shaped filter curve 36 in the graphical representation 34.

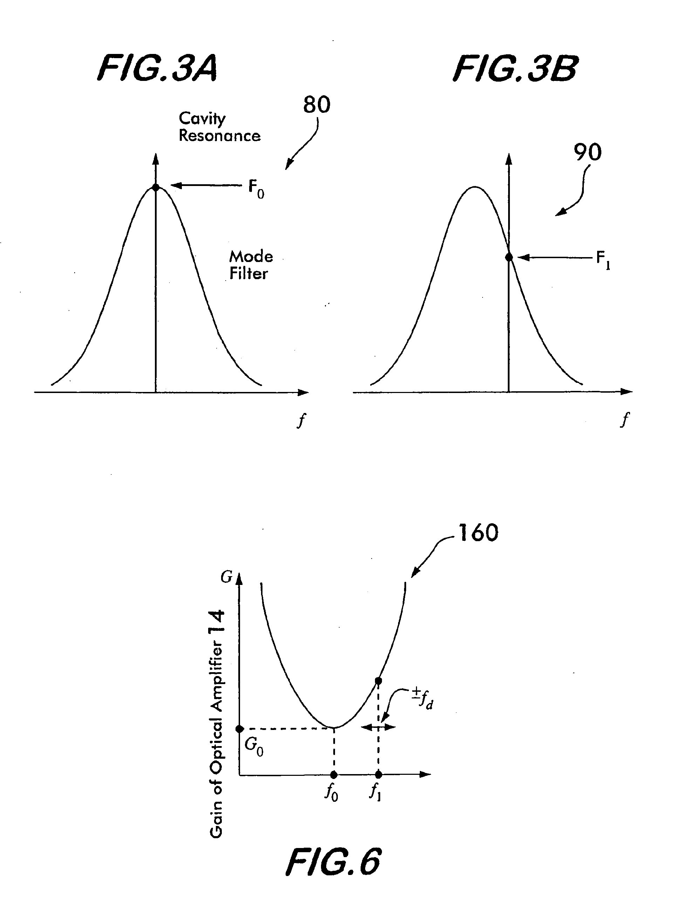

Referring now to Figs. 3A, 3B, there are shown the graphical representations 80, 90. The graphical representation 80 illustrates the case in which the peak response of the mode filter of the external cavity laser system 10 coincides with the resonance frequency of the cavity 28. In this case, let the total cavity transmission be $F_0$, including the both losses due to the filter and the losses due to any other components within the cavity 28. Let the gain of the optical amplifier 14 under these circumstances be

$$G_0 = \frac{1}{F_0}. \qquad \text{Equation (4)}$$

The graphical representation 90 illustrates the case in which the mode filter of the laser system 10 has moved slightly out of synchronization with the cavity resonance. In this case the cavity transmission decreases to $F_1$, and the gain of the optical amplifier 14 must increase to

$$G_1 = \frac{1}{F_1}. \qquad \text{Equation (5)}$$

Significantly, this illustrates that the gain of the optical amplifier 14 is minimized when the cavity 28 and the filter are tuned synchronously.

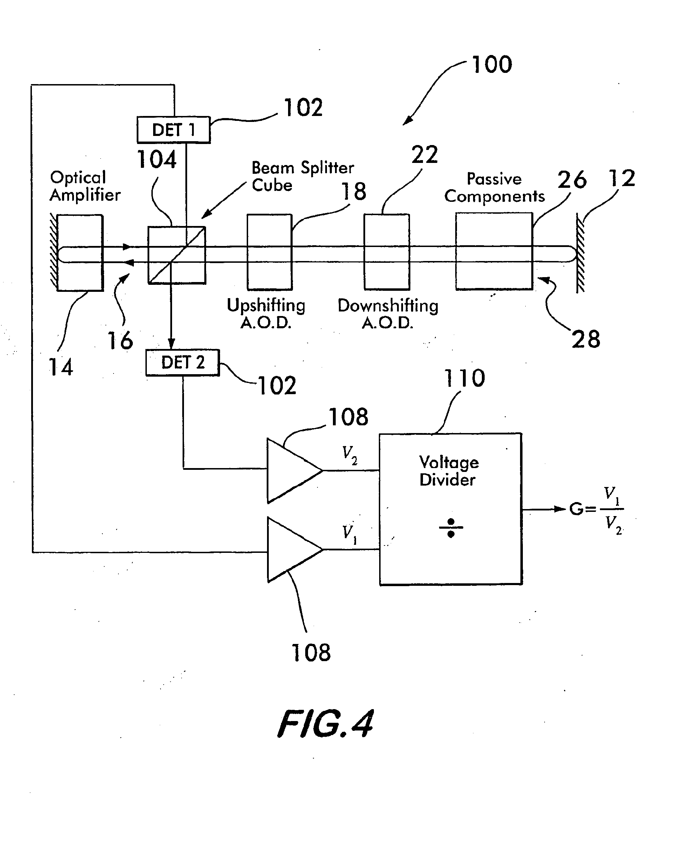

Referring now to Fig. 4, there is shown a schematic representation of the acousto-optically tuned external cavity laser system 100. The acousto-optically tuned external cavity laser system 100 illustrates some of the modifications to the acousto-optically tuned external cavity laser system 10 required to perform the foregoing synchronous tuning of the present invention in one preferred embodiment. In this preferred embodiment of the invention the gain G of an optical amplifier 14 is measured during the synchronous tuning of the present invention in order to make the determinations of Equations (4) and (5).

Within the external cavity laser system 100 the light beams 16 entering and leaving the optical amplifier 14 are sampled using a beam splitter cube 104. The beam splitter cube 104 should pass most of the light propagating through the cavity 28 of the external cavity laser system 100 in order to minimize cavity losses. In a preferred embodiment of the invention a beam splitter reflectance ratio of 1 % or less can be sufficient. Furthermore, it will be understood that a beam splitter such as the beam splitter cube 104 is not necessarily required within the external cavity laser system 100. In alternate embodiments of the invention devices such as a suitably coated plate or pellicle can be used instead of the beam splitter cube 104.

The light sampled by the beam splitter cube 104 is applied to the detectors 102 which provide output signals representative of the sampled fluxes. The outputs of the detectors 102 are applied to the transresistance amplifiers 108 which amplify the signals and apply the voltages $V_1$ and $V_2$ to the voltage divider 128, wherein the voltages $V_1$ and $V_2$ are representative of the light fluxes provided by the beam splitter cube 104. The gain G of the optical amplifier 14 is thus calculated as the quotient of $V_1$ and $V_2$ within voltage divider 110.

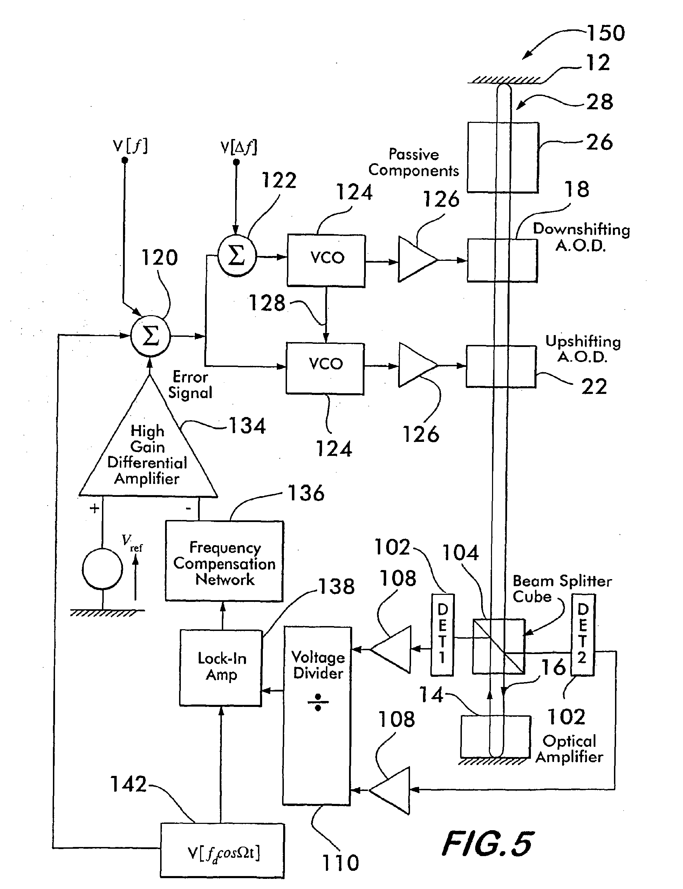

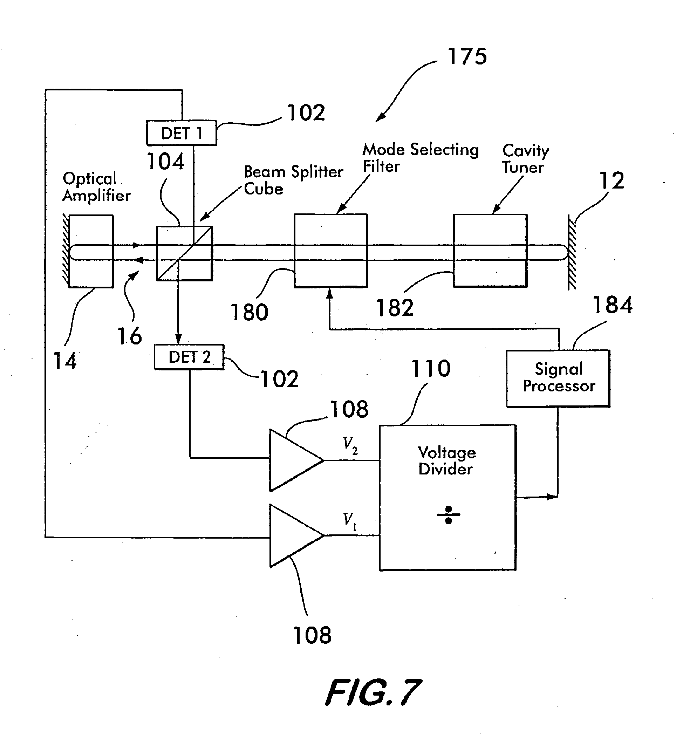

Referring now to Figs. 5, 6, there are shown the graphical representation 160 and the schematic representation of the acousto-optically tuned external cavity laser system 150. The acousto-optically tuned external cavity laser system 150 illustrates some of the modifications to the acousto-optically tuned external cavity laser system 100 for performing the servo method of synchronous tuning of the present invention in one preferred embodiment. Therefore, the acousto-optically tuned external cavity laser system 150 is referred to as the servo tuned laser system 150. The graphical representation 160 illustrates the optical gain of the optical amplifier 14 within the servo tuned laser system 150 as a function of the acoustic frequency f.

Although the servo tuned laser system 150 illustrates one possible embodiment of the servo system and method of the present invention, it will be understood that many other embodiments of the inventive system and method are possible. For example, the term servo is understood herein to include any device for sensing an error signal and providing a correction signal adapted to decrease the error signal, whether the servo device is mechanical or non mechanical, electrical or optical. Furthermore, for clarity in the description that follows it is assumed that analog electronics are used in at least portions of the servo tuned laser system 150. However, the principles described herein also apply to digital implementations. Furthermore, although the description herein is provided in terms of an acousto-optically tuned laser system, the invention can be applied to other types of laser systems. For example, the invention can be applied to mechanically tuned laser systems. Additionally, the invention can be applied to laser systems having a ring cavity as well as laser systems having a linear configuration.

Using the servo tuned laser system 150 of the present invention the gain of the optical amplifier 14 can be maintained at a minimum value Go using a servo loop which is described in more detail below. In order to illustrate this, assume that the resonance of the cavity 28 of the servo tuned laser system 150 is fixed. Additionally, assume that the pass frequency of the filter of the laser system 150 is adjusted by changing the acoustic frequency $f$. The resulting change in optical amplifier gain can be described with reference to the graphical representation 160. At frequency $f_0$, the filter peak coincides with the resonating cavity mode. As a result, the cavity transmission is maximized. Thus, the gain of the optical amplifier 14 must therefore be at a minimum value.

The gain versus acoustic frequency $f$ curve in the graphical representation 160 is modeled as a quadratic of the form

$$G = G_0 + A(f - f_0)^2 \qquad \text{Equation (6)}$$

where A and Go (the minimum gain) are constants.

Assume that the acoustic frequency is set at $f_1$, and that a small sinusoidal FM dither signal of modulation depth $\pm f_d$ and modulation frequency $\Omega$ is superimposed such that, at time t, the instantaneous acoustic frequency is

$$f = f_1 + f_d \cos \Omega t \qquad \text{Equation (7)}$$

Combining equations (6) and (7) yields

$$G = G_0 + A[(f_1 - f_0) + f_d \cos\Omega t]^2 \qquad \text{Equation (8)}$$

Equation (8) may be rewritten as

$$G = G_0 + A[(f_1 - f_0)^2 + \tfrac{1}{2}f_d^2] + 2A(f_1 - f_0)f_d \cos\Omega t + \tfrac{1}{2}Af_d^2 \cos 2\Omega t . \qquad \text{Equation (9)}$$

$$\overleftrightarrow{\hspace{3cm}} \qquad \overleftrightarrow{\hspace{2cm}} \qquad \overleftrightarrow{\hspace{1.5cm}}$$

DC  Fundamental  2nd harmonic

Note that in Equation (9), the fundamental term in $\Omega$ is proportional to $(f_1-f_0)$. Therefore, the fundamental term in $\Omega$ is zero when the cavity resonance is perfectly synchronized with the mode filter. This suggests that this fundamental could be used to derive the error signal in a servo loop for synchronizing the tuning of the laser.

Within the servo tuned laser system 150 the upshifting A.O.D. 18 and the downshifting A.O.D. 22 are driven by the respective voltage controlled oscillators (VCO) 124 by way of the power amplifiers 126. The VCOs 124 are frequency locked to each other as shown at frequency lock connection 128. The outputs of the VCOs 124 provide the frequency signals $f_1$ and $f_2$ as previously described with respect to the external cavity laser system 10. Thus, the difference between the drive frequencies applied by the VCOs 124 to the upshifting A.O.D. 18 and downshifting A.O.D. 22 is $\Delta f$

The frequency difference $\Delta f$ controls the cavity F.S.R. and hence the possible cavity resonance modes of the servo tuned laser system 150. The analog summing circuit 122 receives the frequency difference $\Delta f$ as the input voltage $V[\Delta f]$. It will be understood that the square parentheses shown herein indicate that when a voltage $V[x]$ is applied to a VCO 124, its output is a sinusoid of frequency x Hz. The frequency f is another input parameter of the servo tuned laser system 150. The frequency f determines the optical frequency of the peak of the mode filter. It is applied to the analog summing circuit 120 as the input voltage $V[f]$. For exact synchronous tuning of a laser in the prior art laser tuning systems f and $\Delta f$ were required to satisfy Equation (3) exactly. However, the system and method of the present invention permit synchronous tuning of the servo tuned laser system 150 to be performed even if Equation (3) is only approximately satisfied.

The error signal of the servo tuned laser system 150 is derived from the measured gain of the optical amplifier 14. The measured gain is obtained using the beamsplitter cube 104 to sample the two light beams 16. Signals representative of the sampled light beams 16 obtained in this manner are applied to the voltage divider 110 by way of the detectors 108 and the transresistance amplifiers 108. The measured gain of the optical amplifier 14 is calculated within the analog voltage divider 110 as the quotient of the two signals applied to the analog voltage divider 110 by the transresistance amplifiers 108.

The measured gain at the output of the voltage divider 110 forms the input to the lock-in amplifier 138. Additionally, a sine wave signal generator 142 produces the FM dither signal with a frequency $\Omega$. The FM dither signal provided by the sine wave signal generator 142 is combined with $V[f]$ by the analog summing circuit 120. The sine wave provided at the output of the signal generator 142 also acts as the reference for the lock-in amplifier 138.

The output of the lock-in amplifier 138 is proportional to the $\Omega$ frequency component of the measured gain of the optical amplifier 14 as determined in the voltage divider 110. As described above, this fundamental component is proportional to the difference in optical frequencies between the resonant cavity mode and the peak of the mode filter. The output voltage of the lock-in amplifier 138 is filtered by a frequency compensation network 136 in order to stabilize the servo loop within the servo tuned laser system 150.

A reference voltage $V_{REF}$ is also applied to a high gain differential amplifier 134 along with the output of the frequency compensation network 136. By comparing these two input signals the high gain differential amplifier 134 can determine the error signal within the laser system 150. If the cavity mode of the laser system 150 is to be synchronized to the peak of the mode filter pass band, the voltage $V_{REF}$ can be set to zero. However, in some embodiments of the invention it may be advantageous to offset the mode filter peak and the cavity mode by a small but consistent frequency. In this case, $V_{REF}$ can be set to an appropriate non-zero value.

The error signal provided by the differential amplifier 134 is applied to the summing circuit 120 in order to add the error signal to $V[f]$ which is also applied to the summing circuit 120. Additionally, the sinusoidal FM dither signal V

*[f<sub>a</sub>cosΩ)]* generated in the dither signal block 142 is superimposed on *V[f]* in the summing circuit 120. The output signal of the summing circuit 120 is used to control the output frequencies of the VCOs 124, and thereby the frequencies applied to the A.O.D.s 18, 22 and the frequency shifting of the light beams 16. It is applied directly to the VCO 124 of the downshifting A.O.D. 22 and it is summed with *V[Δf]* in the summing circuit 168 before being applied to the VCO 124.

Referring now to Fig. 7, there is shown the linear cavity laser system 175. The linear cavity laser system 175 provides a more generalized representation of the system and method of the invention. It includes the end reflectors 12, for example, mirrors or gratings, and the optical amplifier 14 for overcoming cavity losses, as previously described. A mode select filter 180 selects the mode in which the cavity 28 of the laser oscillates and a cavity tuner 182 selects the frequency of oscillation. It will be appreciated by those skilled in the art that the generalized representation of the invention applies to lasers having a ring cavity as well as lasers having a linear cavity.

In the case of a tuned laser, a beam splitter cube 104 or other equivalent device such as a pellicle is provided within the cavity 28. The beam splitter cube 104 diverts a small amount of the light incident upon, and leaving from, the optical amplifier 14 to the photodetectors 102. The electrical outputs of the photodetectors 102 are amplified by amplifiers 108 and divided in the voltage divider 110. In this manner, the gain of the optical amplifier 14 is measured. Signal processing is performed upon the measured gain signal at the output of the voltage divider 110 by a signal processor 184. The output of the signal processor 184 is applied to the mode select filter 180 for adjusting the mode selection to provide synchronous tuning of the laser system 175.

According to the method of the invention the mode select filter 180 maintains the gain of the optical amplifier 14 at, or near , a minimum value as the cavity 28 is tuned to change the output frequency of the laser system 175. In this manner, the laser always oscillates in the same mode, without mode hops, as its output frequency is changed in the linear cavity laser system 175.

Thus, the gain of the optical amplifier 14 is held at or near a minimum value by a servo loop in which a feedback signal derived from the measured gain is applied to the mode select filter by way of the signal processor 184. The servo loop within the linear cavity laser system 175 can be any kind of servo loop, including any type of mechanical loop. The signal processor 184 can consist of components which can include, but are not be limited to, signal amplifiers, filters and lock-in amplifiers.

In one preferred embodiment of the invention the laser is tuned by acousto-optic tuning. However, it will be understood that any known apparatus or method for frequency tuning responsive to the servo loop can be used. In the case where acousto-optic tuning is used, the cavity of the laser is tuned using the frequency shift that occurs when light interacts with the sound wave in an acousto-optic device. To obtain well controlled cavity tuning in this manner, it is preferred that two such devices provide frequency shifting within the cavity, an upshifter and a downshifter. The mode filtering can also be performed by the acousto-optic devices. For example, if the acousto-optic devices are filters, they act directly as mode filters. If the acousto-optic devices are deflectors, they are generally used in conjunction with diffraction gratings to form the mode filter.

While the invention has been described in detail and with reference to specific examples thereof, it will be apparent to one skilled in the art that various changes and modifications can be made therein without departing from the spirit and scope thereof.

**Claims**

1.  A method for synchronously tuning a laser in a laser system (150) having a set of possible resonant frequencies including a resonating mode resonant frequency (38, 52), an optical amplifier (14) with an optical gain and a mode filter (180) having a pass band (36, 50) with a center frequency, comprising the steps of:

    determining said optical gain of said optical amplifier (14);
    providing an optical gain signal representative of said optical gain; and
    adjusting said center frequency of said pass band (36, 50) in accordance with said optical gain signal to move said center frequency of said pass band (36, 50) toward said resonating mode resonant frequency (38, 52).

2.  The method for synchronously tuning a laser in a laser system (150) of claim 1, comprising the further steps of:

    determining an error signal in accordance with said optical gain signal; and
    adjusting said center frequency of said pass band (36, 50) by a servo system in accordance with said error signal.

3.  The method for synchronously tuning a laser in a laser system (150) of claim 1, comprising the further step of adjusting said center frequency of said pass band (36, 50) in accordance with a signal representative of an acoustic frequency.

4. The method for synchronously tuning a laser in a laser system (150) of claim 1, wherein said laser system (150) includes an acousto-optic device (18, 22) comprising the further step of shifting said center frequency of said pass band (36, 50) by said acousto-optic device (18, 22).

5. The method for synchronously tuning a laser in a laser system (150) of claim 4, including a signal representative of an acoustic frequency comprising the further step of shifting said center frequency of said pass band (36, 50) by said acousto-optic device (18, 22) in accordance with said signal representative of said acoustic frequency.

6. The method for synchronously tuning a laser in a laser system (150) of claim 1, comprising the further steps of:

   determining a minimum value of said optical gain; and
   adjusting said center frequency of said pass band (36, 50) to maintain said optical gain at said minimum value of optical gain.

7. The method for synchronously tuning a laser in a laser system (150) of claim 6, comprising the further step of adjusting said minimum value of said optical gain signal in accordance with a reference signal.

8. The method for synchronously tuning a laser in a laser system (150) of claim 7, comprising the further step of adjusting said reference signal to provide an offset between said center frequency of said pass band (36, 50) and said resonant frequency (38, 52).

9. An apparatus for synchronously tuning a laser in a laser system (150) having a set of possible resonant frequencies including a resonating mode resonant frequency (38, 52) and a mode filter (180) having a pass band (36, 50) with a center frequency, comprising:

   an optical amplifier (14) having an optical gain; and
   a frequency shifter wherein said frequency shifter shifts said center frequency of said pass band (36, 50) in accordance with said optical gain to move said center frequency of said pass band (36, 50) toward said resonating mode resonant frequency (38, 52).

10. The apparatus for synchronously tuning a laser in a laser system (150) of claim 9, further comprising a servo system wherein said servo system adjusts said center frequency of said pass band (36, 50) in accordance with said optical gain.

## FIG.1

PRIOR ART

## FIG.2

## FIG.3A

Cavity
Resonance

80

F$_0$

Mode
Filter

$f$

## FIG.3B

90

F$_1$

$f$

160

$G$

Gain of Optical Amplifier 14

$G_0$

$\pm f_d$

$f_0$  $f_1$

## FIG.6

_100_

_102_

DET 1

_104_

Optical
Amplifier

Beam Splitter
Cube
_18_

_22_

Passive
Components

_26_  _12_

Upshifting
A.O.D.

Downshifting
A.O.D.

_28_

_14_

_16_

DET 2

_102_

_108_

$V_2$

_110_

Voltage
Divider

÷

$G = \dfrac{V_1}{V_2}$

$V_1$

_108_

**FIG.4**

**FIG.5**

FIG.7